# EUROPEAN PATENT APPLICATION

(11) **EP 1 480 275 A2**
(43) Date of publication of application: **24.11.2004**
(21) Application number: 04252910.7
(22) Date of filing: 19.05.2004
(51) Int. Cl.: H01L 29/792

(54) **SONOS memory device having nanocrystal layer**

(30) Priority: 20.05.2003 KR 2003031909
(71) Applicant: Samsung Electronics Co., Ltd., Suwon-si, Gyeonggi-do (KR)
(72) Inventor: Kim, Ju-hyung, c/o Ga-401 Jeongam Villa, Yongin-si, Gyeonggi-do (KR); Kim, Chung-woo, c/o 101-705 Parktown Daelim, Seongnam-si, Gyeonggi-do (KR); Chae, Soo-doo, c/o 326-301 Sibeom-danji Hanyang, Seongnam-si, Gyeonggi-do (KR); Jeong, Youn-seok, Seoul (KR)
(74) Representative: Greene, Simon Kenneth

(57) **Abstract**

Provided is a SONOS memory device having nanocrystal layers. The SONOS memory device includes a memory type transistor including a gate with a SONOS structure on a semiconductor substrate. The gate is formed by sequentially stacking a tunneling oxide layer, a memory node layer having a trap site in which charges passing through the tunneling oxide layer are trapped, and a gate electrode. The memory node layer includes a crystal layer composed of nanocrystals that are separated from one another to trap the charges.

## Description

The present invention relates to a semiconductor memory device, and more particularly, to a SONOS memory device having nanocrystal layers, thus improving integration without increasing the size of the SONOS memory device.

The data storage capacity of a semiconductor memory device is proportional to the number of memory cells per unit area, in other word, the integration of the memory device. The semiconductor memory device includes a plurality of memory cells that are connected in a circuit.

In general, one memory cell of the semiconductor memory device, for example, a DRAM, includes one transistor and one capacitor. Accordingly, in order to increase the integration of the semiconductor device, the size of the transistor and/or the capacitor should be reduced.

A semiconductor memory device having a low integration has sufficient process margins in photolithography and etch processes. Accordingly, the integration of the semiconductor memory device could be increased by reducing the size of the transistor and/or the capacitor.

As semiconductor technology and related electronic technology is improved, a semiconductor memory device having higher integration is required. However, reducing the size of the transistor and/or the capacitor cannot satisfy the requirement.

On the other hand, the integration of the semiconductor memory device is closely related to a design rule applied to the manufacturing process of the semiconductor memory device. Accordingly, in order to improve the integration of the semiconductor memory device, a strict design rule should be applied to the manufacturing process thereof, which results in the photolithography and etch processes having low process margins. In other words, more precise photolithography and etch processes should be applied to the manufacturing of the semiconductor memory device.

When the margins of the' photolithography and etch processes in the manufacturing process of the semiconductor memory device are decreased, yield also decreases. Accordingly, a method of increasing the integration of the semiconductor memory device while preventing the decrease in the yield is needed.

Thus, a semiconductor memory device having a structure different from that of conventional semiconductor memory devices is provided by arranging a data storage medium, such as GMR or TMR, in which data are stored in different methods from the conventional capacitor, on the transistor.

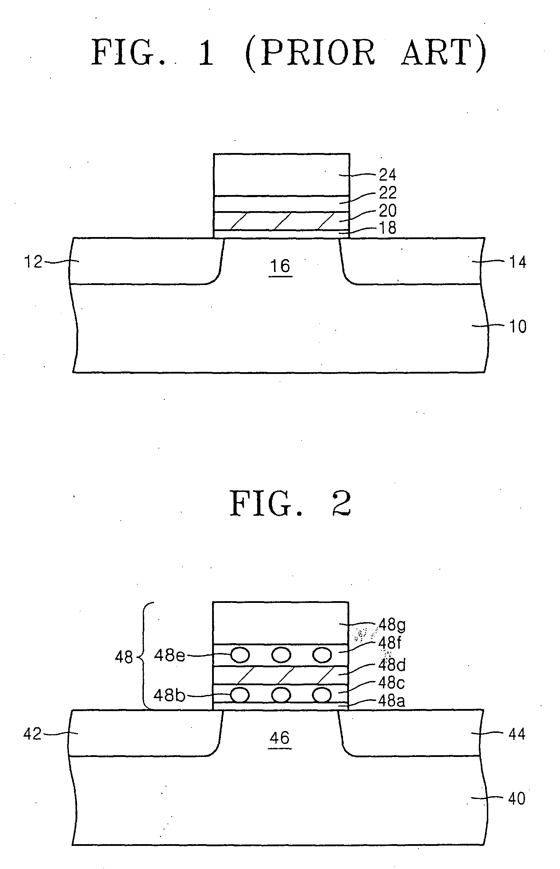

A SONOS memory device is such a semiconductor memory device. FIG. 1 is a sectional view of a conventional SONOS memory device.

Referring to FIG. 1, a conventional SONOS memory device includes a p-type semiconductor substrate 10, which will be referred to as a semiconductor substrate. A source region 12 and a drain region 14 doped with an n-type conductive impurity are formed in the semiconductor substrate 10, and a channel region 16 exists between the source and drain regions 12 and 14. A tunneling oxide layer 18, which contacts the source and drain regions 12 and 14, is formed on the channel region 16 of the semiconductor substrate 10. On the tunneling oxide layer 18, a nitride layer (Si₃N₄) 20 and a blocking oxide layer 22 are sequentially deposited. A gate electrode 24 is formed on the blocking oxide layer 22. The nitride layer 20 includes a trap site to trap electrons, which pass through the tunneling oxide layer 18. The blocking oxide layer 22 prevents the trapped electrons from flowing to the gale electrode 24.

The threshold voltage of the conventional SONOS memory device when the electrons are trapped in the trap site of the nitride layer 20 is different from the threshold voltage when the electrons are not trapped. The conventional SONOS memory device may store and reproduce information. However, the conventional SONOS memory device can store only one bit of information per cell. Accordingly, the size of the cells must be reduced to improve the integration.

To this end, the volume of the SONOS memory device of FIG. 1 should be reduced, which requires a strict design rule in the photolithography process. However, it is difficult to strictly apply the design rule due to a limitation of the resolution of the photolithography process.

As a result, while the conventional SONOS memory device may have higher integration than the semiconductor memory device formed of one transistor and one capacitor, the conventional SONOS memory device still has limited integration due to a limitation of the photography process.

According to an aspect of the present invention, there is provided a SONOS memory device including a memory type transistor in which a gate is formed with a SONOS structure on a semiconductor substrate, wherein the gate comprises a tunneling oxide layer, a memory node layer formed on the tunneling oxide layer and having a trap site in which charges passing through the tunneling oxide layer are trapped, and a gate electrode formed on the memory node layer, wherein the memory node layer includes a crystal layer composed of nanocrystals that are separated from one another to trap the charges.

The present invention may provide a SONOS memory device manufactured with the same design rule as a conventional SONOS memory device, wherein a larger amount of data is stored in a unit memory cell than in the unit memory cell of the conventional SONOS memory device, thus increasing integration.

The memory node layer may include first through third memory node layers, and at least one of the first through third memory node layers comprises a crystal layer that does not contact adjacent memory node layers.

The first memory node layer and the third memory node layer may comprise the crystal layer, and the second memory node layer may comprise the crystal layer.

In the former case, the second memory node layer may be a dielectric layer having a trap site with a predetermined density. In the latter case, each of the first and third memory node layer may be a dielectric layer having trap sites with a predetermined density.

An insulating layer may be interposed between the crystal layer and the adjacent memory node layer.

A blocking oxide layer may be interposed between the third memory node layer and the gate electrode.

According to another aspect of the present invention, there is provided a SONOS memory device including a memory type transistor in which a gate is formed with a SONOS structure on a semiconductor substrate, wherein the gate comprises a tunneling oxide layer, a memory node layer formed on the tunneling oxide layer and having a trap site in which charges passing through the tunneling oxide layer are trapped, and a gate electrode formed on the memory node layer, wherein the memory node layer includes a nano-sized trap element in which the charges are trapped.

The memory node layer may include first through third memory node layers stacked sequentially, at least one of the first through third memory node layers may include the trap element, and the trap element does not contact adjacent memory node layers. Here, the first memory node layer and the third memory node layer may comprise the trap element, and the second memory node layer may comprise the trap element.

In the former case, the second memory node layer may be a dielectric layer having a trap site with a predetermined density. In the latter case, each of the first and third memory node layers may be a dielectric layer having a trap site with a predetermined density.

The trap element may be a crystal layer composed of nanocrystals that are separated from one another.

According to the present invention, multiple bits of information may be recorded in one memory cell. Therefore, although a memory device according to the present invention has the same cell size as a conventional SONOS memory device, the integration of the memory device according to the present invention is increased over the conventional memory device in which one bit is recorded in one memory cell.

The above and other features and advantages of the present invention will become more apparent by describing in detail exemplary embodiments thereof with reference to the attached drawings in which:
FIG. 1 is a sectional view of a conventional SONOS memory device;
FIG. 2 is a sectional view of a SONOS memory device having a nanocrystal layer according to a first embodiment of the present invention;
FIG. 3 is a sectional view of a SONOS memory device having a nanocrystal layer according to a second embodiment of the present invention;
FIG. 4 is a sectional view illustrating a case where carriers are trapped in a first memory node layer of the SONOS memory device of FIG. 2;
FIG. 5 is a sectional view illustrating a case where carriers are trapped in first and second memory node layers of the SONOS memory device of FIG. 2;
FIG. 6 is a sectional view illustrating a case where carriers are trapped in first through third memory node layers of the SONOS memory device of FIG. 2; and
FIG. 7 is a graph illustrating the shifts of a threshold voltage by trapping carriers in memory node layers of the SONOS memory device of FIG. 2.

A SONOS memory device according to the present invention will now be described more fully with reference to the accompanying drawings, in which exemplary embodiments of the invention are shown. In the drawings, the thicknesses of layers and regions are exaggerated for clarity.

A SONOS memory device according to a first embodiment of the present invention will now be described with reference to FIG. 2.

Referring to FIG. 2, the SONOS memory device according to the first embodiment of the present invention includes a p-type semiconductor substrate 40, which will be referred to as a semiconductor substrate. A source region 42 and a drain region 44 are formed in the semiconductor substrate 40 by injecting an n-typed conductive impurity to a predetermined depth in the semiconductor substrate 40, and a channel region 46 is formed between the source region 42 and the drain region 44. A first gate stacking material 48 is formed on the channel region 46 of the semiconductor substrate 40. Both edges of the bottom of the first gate stacking material 48 contact the source region 42 and the drain region 44. The first gate stacking material 48 includes a first tunneling oxide layer 48a, for example, a silicon oxide layer (SiO₂), which contacts the entire surface of the channel region 46 and portions of the source and drain regions 42 and 44, and a first memory node layer 48b and 48c, a second memory node layer 48d, a third memory node layer 48e and 48f, and a first gate electrode 48g that are sequentially stacked on the first tunneling oxide layer 48a. The first memory node layer 48b and 48c includes a first crystal layer 48b and a first insulating layer 48c. The first crystal layer 48b is composed of a nano-sized trap material, in other words, a plurality of nanocrystals that are formed on the first tunneling oxide layer 48a. The first insulating layer 48c prevents the first crystal layer 48b from contacting the second memory node layer 48d. The second memory node layer 48d is a dielectric layer, for example, a nitride layer (Si₃N₄), having a trap site of a predetermined density. The third memory node layer 48e and 48f includes a second crystal layer 48e and a second insulating layer 48f. The second crystal layer 48e is composed of a nano-sized trap material. The second insulating layer 48f prevents the second crystal layer 48e from contacting the second memory node layer 48d and the gate electrode 48g, and prevents electrons trapped in the second crystal layer 48e from flowing to the gate electrode 48g. Accordingly, the second crystal layer 48e can be embedded in the second insulating layer 48f.

The first crystal layer 48b and the second crystal layer 48e of the first gate stacking layer 48 can be composed of the same material, however, the first and the second crystal layers 48b and 48e may also be composed of different crystals. The first insulating layer 48c can be a silicon oxide layer or can be composed of another insulating material. The second insulating layer 48f, which is a blocking insulating layer for blocking the flow of electrons to the first gate electrode 48g, can be a silicon oxide layer or another insulating layer.

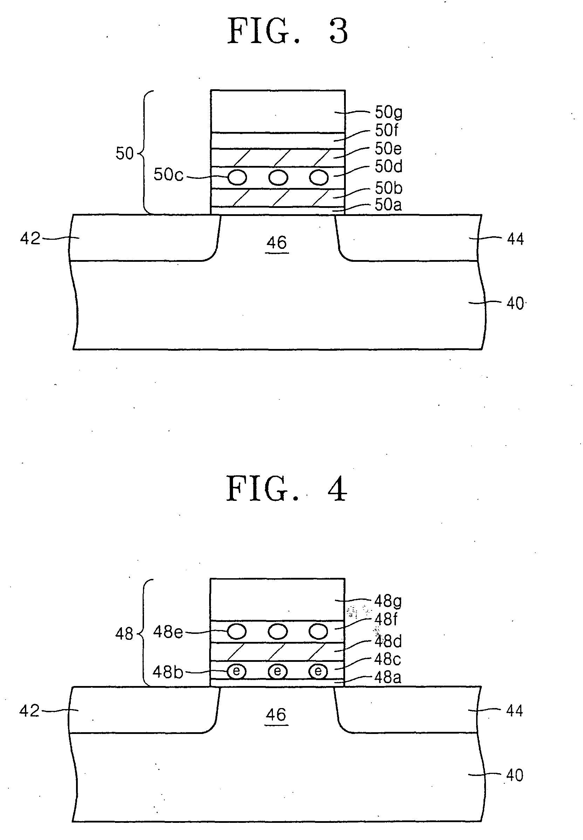

A SONOS memory device according to a second embodiment of the present invention will now be described with reference to FIG. 3. The same reference numerals used in FIG. 2 will be used for the same elements in FIG. 3.

Referring to FIG. 3, a source region 42 and a drain region 44 are formed at the both sides of a channel region 46 in a semiconductor substrate 40. A gate stacking material 50 is formed on a channel region 46 of the semiconductor substrate 40. The gate stacking material 50 includes a tunnelling oxide layer 50a, a fourth memory node layer 50b, a memory node layer 50c and 50d, a memory node layer 50e, a blocking oxide layer 50f, and a gate electrode 50g stacked sequentially. The tunnelling oxide layer 50a is the same as the first tunneling oxide layer 48a of the first embodiment. The memory node layer 50b is a dielectric layer, for example, a nitride layer (Si₃N₄), having a trap site of a predetermined density. Electrons passing through the tunnelling oxide layer 50a are trapped in the memory node layer 50b. The memory node layer 50c and 50d is the same as the first memory node layer 48b and 48c or the third memory node layer 48e and 48f of the first embodiment. In other words, the memory node layer 50c and 50d includes a crystal layer 50c and an insulating layer 50d. The crystal layer 50c is composed of nanocrystals that are separated from one another. The insulating layer 50d includes the crystal layer 50c and prevents the crystal layer 50c from contacting the memory node layers 50b and 50e. The memory node layer 50e is a dielectric layer, for example, a nitride layer, having a trap site of a predetermined density.

The threshold voltages of the SONOS memory devices according to the first and second embodiments of the present invention are changed by trapping electrons in the memory node layers.

The changes in the threshold voltage of the SONOS memory device will be described with reference to the SONOS memory device according to the first embodiment of the present invention.

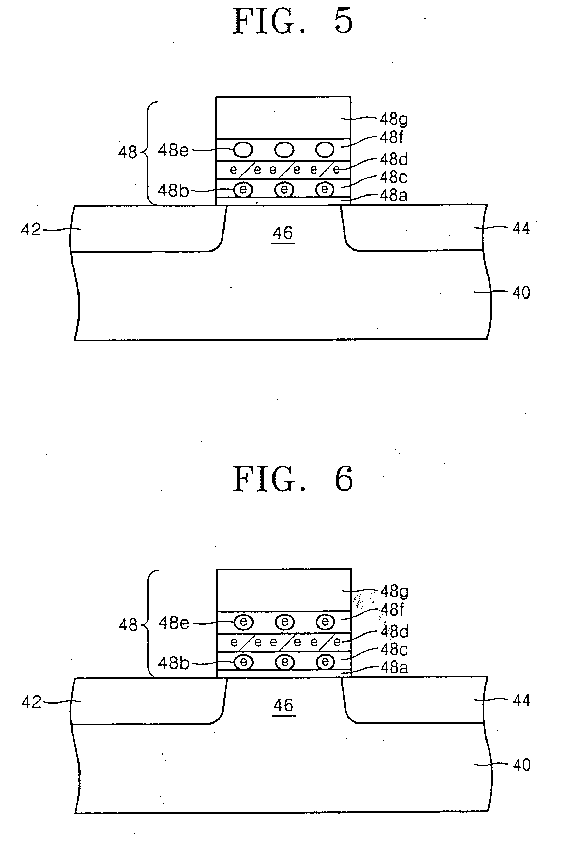

FIG. 4 is a sectional view illustrating a first case where electrons e are trapped in the first memory node layer 48b and 48c. FIG. 5 is a sectional view illustrating a second case where the electrons e are trapped in the first memory node layer 48b and 48c, and the second memory node layer 48d. FIG. 6 is a sectional view illustrating a third case where the electrons e are trapped in the first through third memory node layers 48b, 48c, 48d, 48e, and 48f.

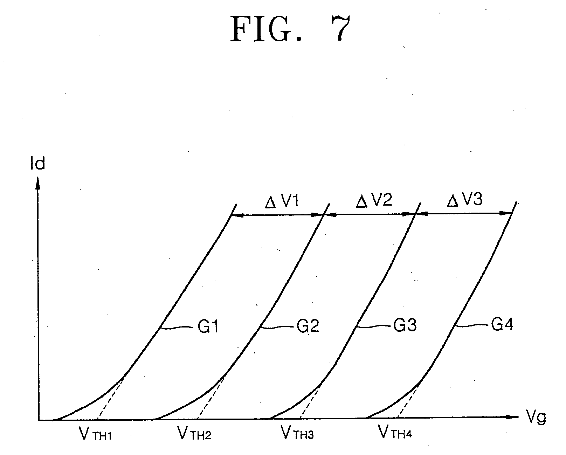

FIG. 7 is a graph illustrating the threshold voltage shift of the SONOS memory device according to the first through third cases. Reference character G1 of FIG. 7 denotes the threshold voltage in the case where the electrons e are not trapped in the first through third memory node layers 48b, 48c, 48d, 48e, and 48f. Reference characters G2 through G4 of FIG. 7 respectively denote the threshold voltages in the first through third cases.

Referring to FIG. 7, the threshold voltage V_{TH2} of the SONOS memory device in the first case is obtained by shifting the threshold voltage V_{TH1} in the case where the electrons are not trapped in the memory node layers by ΔV1. In addition, the threshold voltage V_{TH3} of the SONOS memory device in the second case is obtained by shifting the threshold voltage V_{TH2} in the first case by ΔV2. In addition, the threshold voltage V_{TH4} of the SONOS memory device in the third case is obtained by shifting the threshold voltage V_{TH3} in the second case by ΔV3.

Since the SONOS memory device according to the first embodiment of the present invention includes four different states according to the trapped states of the electrons, one SONOS memory device may store two-bits data, for example, "00", "01", "10", or "11". Accordingly, the integration of the SONOS memory device according to the first embodiment of the present invention is more than twice the integration of a conventional SONOS memory device.

As described above, the SONOS memory device according to the present invention includes the first through third memory node layers, wherein at least one memory node layer includes the crystal layer formed of the nanocrystals. Accordingly, the SONOS memory device according to the present invention may have four different states having two-bits data in one memory cell and the integration of the memory device is almost double the integration of a conventional SONOS memory device in which one bit is recorded in one memory cell.

While the present invention has been particularly shown and described with reference to exemplary embodiments thereof, it will be understood by those of ordinary skill in the art that various changes in form and details may be made therein without departing from the scope of the present invention as defined by the following claims.

## Claims

1. A SONOS memory device including a memory type transistor in which a gate is formed with a SONOS structure on a semiconductor substrate, wherein the gate comprises:
a tunneling oxide layer;
a memory node layer formed on the tunneling oxide layer and having a trap site in which charges passing through the tunneling oxide layer are trapped; and
a gate electrode formed on the memory node layer,
wherein the memory node layer includes at least one nano-sized trap element in which the charges are trapped.

2. The SONOS memory device of claim 1, wherein the memory node layer includes first through third memory node layers stacked sequentially at least one of the first through third memory node layers includes the trap element, and the trap element does not contact adjacent memory node layers.

3. The SONOS memory device of claim 2, wherein the first memory node layer and the third memory node layer comprise the trap element.

4. The SONOS memory device of claim 2, wherein the second memory node layer comprises the trap element.

5. The SONOS memory device of any preceding claim, wherein the trap element is a crystal layer composed of nanocrystals that are separated from one another.

6. The SONOS memory device of claim 3, wherein the second memory node layer is a dielectric layer having a trap site with a predetermined density.

7. The SONOS memory device of claim 4, wherein each of the first and third memory node layers is a dielectric layer having a trap site with a predetermined density.

8. A SONOS memory device according to any preceding claim wherein the memory node layer includes a crystal layer composed of nanocrystals as the trap element, the nanocrystals being separated from one another to trap the charges.

9. The SONOS memory device of claim 8, wherein the memory node layer includes first through third memory node layers, and at least one of the first through third memory node layers comprises a crystal layer that does not contact adjacent memory node layers.

10. The SONOS memory device of claim 9, wherein the first memory node layer and the third memory node layer comprise the crystal layer.

11. The SONOS memory device of claim 9, wherein the second memory node layer comprises the crystal layer.

12. The SONOS memory device of claim 9, 10 or 11, wherein an insulating layer is interposed between the crystal layer and the adjacent memory node layer.

13. The SONOS memory device of claim 6 or 7, wherein the or each dielectric layer is a nitride layer.

14. The SONOS memory device of any of claims 2 to 7 or 9 to 13, wherein a blocking oxide layer is interposed between the third memory node layer and the gate electrode.
